# FASCICULE DE BREVET EUROPEEN

(11) **EP 3 839 659 B1**
(45) Date de publication et mention de la délivrance du brevet: **03.04.2024**
(21) Numéro de dépôt: 19216709.6
(22) Date de dépôt: 16.12.2019
(51) Int. Cl.: C23C 2/00, C23C 2/02, A44C 27/00, G04B 19/12, G04B 29/02, G04B 37/22, G04B 45/00, G04B 19/10, G04B 19/18

(54) **PROCÉDÉ DE DÉCORATION D'UNE PIÈCE MÉCANIQUE**
VERFAHREN ZUR DEKORATION EINES MECHANISCHEN BAUTEILS
METHOD FOR DECORATING A MECHANICAL PART

(43) Date de publication de la demande: 23.06.2021
(73) Titulaire: Rubattel et Weyermann S.A., 2300 La Chaux-de-Fonds (CH)
(72) Inventeur: JEANRENAUD, Frédéric, 2300 La Chaux-de-Fonds (CH)
(74) Mandataire: ICB SA

(56) Documents cités:
- EP-A1- 2 370 865
- EP-A1- 2 380 864
- EP-A1- 3 246 767
- EP-A1- 3 536 826
- EP-A1- 3 575 447
- EP-B1- 2 370 865
- JP-A- 2008 150 660

## Description

### Domaine technique de l'invention

La présente invention concerne un procédé de décoration d'une pièce mécanique. Plus précisément, l'invention concerne un procédé de décoration d'une pièce mécanique utilisée dans le domaine de l'horlogerie ou de la bijouterie.

### Arrière-plan technologique de l'invention

De nombreux procédés pour la réalisation de décors en relief sur une surface d'une pièce mécanique telle qu'un cadran de montre ou une lunette sont connus dans l'état de la technique. Parmi tous ces procédés connus, un certain nombre d'entre eux consistent à fabriquer les éléments de décor séparément de la pièce mécanique à décorer, puis à fixer ces éléments de décor sur la pièce mécanique à laquelle ils sont destinés.

Un autre procédé de décoration d'une pièce mécanique telle qu'un cadran est connu par la demande de brevet européen EP 2 370 865 A1 au nom de The Swatch Group Research and Development Ltd. Ce procédé de décoration consiste à :
- se munir de la pièce mécanique à décorer ;
- réaliser un masque du type d'une plaque dont l'épaisseur est au moins égale à l'épaisseur souhaitée des éléments de décor et dans laquelle sont usinées des ouvertures dont les contours correspondent à la forme des éléments de décors recherchés ;
- positionner le masque sur la surface à décorer de la pièce mécanique, de façon que les ouvertures du masque coïncident avec les emplacements de la pièce mécanique destinés à recevoir les éléments de décor ;
- le masque dont l'épaisseur correspond au moins à l'épaisseur souhaitée des éléments de décor forme avec la pièce mécanique à décorer des moules qui vont être remplis d'un matériau de remplissage, et
- retirer le masque pour révéler les éléments de décor à la surface de la pièce mécanique décorée.

Un avantage de ce procédé de décoration réside dans sa relative simplicité de mise en oeuvre. En effet, alors que dans le cas de nombreux procédés de décoration, les éléments de décor sont réalisés séparément de la pièce mécanique à décorer, puis seulement ensuite fixés sur cette pièce mécanique, dans le cas où l'on utilise un masque, les éléments de décor sont directement réalisés et fixés sur la pièce mécanique à décorer dans la même étape du procédé, ce qui permet de réaliser des gains de temps.

Un inconvénient du procédé de décoration au moyen de masques posés à la surface de la pièce mécanique à décorer peut néanmoins être vu dans le fait qu'on ne peut exclure le risque que le masque ne soit pas intimement en contact avec la surface de la pièce mécanique à décorer et qu'au moment du remplissage des différents moules, le matériau de remplissage fuit quelque peu sur la surface de la pièce mécanique, ce qui oblige à mettre certaines de ces pièces mécaniques au rebut. Ceci est problématique en particulier dans le cas où l'on veut décorer des cadrans pour pièces d'horlogerie, car de tels cadrans sont des pièces mécaniques coûteuses.

Le document EP 3 575 447 A1 décrit un procédé de fabrication de décors métalliques sur un cadran bombé en matériau isolant comprenant les étapes consistant à former par photolithographie un moule en résine photosensible, et à déposer par électrodéposition sur une couche métallique des blocs métalliques formant le décor. Le document EP 3 536 826 A1 montre toutes les caractéristiques du préambule de la revendication 1.

### Résumé de l'invention

La présente invention a pour but de remédier aux problèmes mentionnés ci-dessus ainsi qu'à d'autres encore en proposant un procédé de décoration de pièces mécaniques telles qu'un cadran ou une lunette de montre qui évite notamment que les éléments de décors reportés à la surface de la pièce mécanique à décorer ne présentent des bavures qu'il faut éliminer, voire qui conduisent à devoir mettre certaines de ces pièces mécaniques au rebut. La présente invention a également pour but de procurer un procédé de décoration de pièces mécaniques grâce auquel les éléments de décor sont fermement ancrés sur la surface de la pièce mécanique décorée.

A cet effet, la présente invention concerne un procédé de décoration tel que défini dans la revendication 1 annexée.

Grâce à ces caractéristiques, la présente invention procure un procédé de décoration d'une pièce mécanique telle qu'un cadran ou une lunette d'une pièce d'horlogerie dans lequel la couche de masquage est directement formée sur la surface de la pièce mécanique à décorer. On est ainsi assuré que la couche de masquage est en contact intime avec la surface de la pièce mécanique à décorer, de sorte que l'on évite tout risque de coulure, entre la couche de masquage et la surface de la pièce mécanique à décorer, du matériau de remplissage dans lequel vont être faits les éléments de décor, ce qui permet d'obtenir des éléments de décor définis avec une grande précision. En particulier, la forme et l'épaisseur des éléments de décor sont ajustées très précisément. Par ailleurs, il est plus simple, plus rapide et plus économique de former un masque sacrificiel directement à la surface de l'objet à structurer, plutôt que d'usiner un masque séparément de la pièce mécanique à décorer, puis de positionner et plaquer ce masque sur la surface à décorer de la pièce mécanique. On comprendra également que, dans le cas particulier où le matériau utilisé pour la couche de masquage et celui utilisé pour réaliser les éléments de décor ont des duretés voisines, les opérations de finition telles que sablage, brossage, satinage, polissage ou autres sont grandement simplifiées.

Selon des formes spéciales d'exécution, le procédé de décoration d'une pièce mécanique selon l'invention comprend les étapes suivantes :
aménagement, à la suite de la au moins une première cavité, d'au moins une seconde cavité dans la surface à décorer de la pièce mécanique ;
- dépôt d'une première couche d'accrochage sur la surface à décorer de la pièce mécanique, avant dépôt de la couche de masquage, pour favoriser l'accrochage de la couche de masquage ;
- dépôt d'une seconde couche d'accrochage par-dessus la couche de masquage et sur la surface à décorer, aux endroits où sont ménagées les première et éventuellement seconde cavités, pour favoriser l'accrochage des éléments de décor ;
- remplissage du volume délimité par la couche de masquage et la surface à décorer de la pièce mécanique au moyen d'un matériau de remplissage dans lequel on souhaite réaliser les éléments de décor, ce matériau de remplissage étant préférentiellement déposé par croissance galvanique ;
- la première couche d'accrochage de la couche de masquage et la seconde couche d'accrochage des éléments de décor sont déposées par évaporation sous vide ou bien par pulvérisation cathodique ;
- la première couche d'accrochage de la couche de masquage et la seconde couche d'accrochage des éléments de décor sont réalisées en un matériau conducteur de l'électricité ;
- la première couche d'accrochage de la couche de masquage et la seconde couche d'accrochage des éléments de décor se composent d'une couche de chrome (Cr) par-dessus laquelle est déposée une couche d'or (Au) ;
- la couche de chrome et la couche d'or ont chacune une épaisseur de sensiblement 50 nm ;
- la couche de masquage est métallique ;
- la couche de masquage est réalisée en argent (Ag) ou en cuivre (Cu) ;
- l'épaisseur de la couche de masquage est d'au moins 20 µm et, de préférence, comprise entre 20 µm et 400 µm ;
- la couche de masquage est déposée sur la surface à décorer de la pièce mécanique par électroformage ;
- le matériau de remplissage est un métal cristallin ou un métal amorphe ;
- le métal cristallin est de l'or ou du nickel ;
- le métal amorphe est un alliage de platine amorphe, ou bien un alliage de palladium amorphe ou bien un alliage de zirconium amorphe ;
- gravure, à travers la première cavité ménagée dans la couche de masquage et la couche d'accrochage des éléments de décor, d'une seconde cavité dans la surface à décorer de la pièce mécanique ;
- la première cavité dans les couches de masquage et d'accrochage et la seconde cavité dans la surface à décorer sont gravées simultanément au moyen d'un faisceau laser ;
- la profondeur de la seconde cavité gravée dans la surface à décorer de la pièce mécanique n'excède pas 20 µm ;
- la seconde cavité gravée dans la surface à décorer de la pièce mécanique comprend des moyens d'ancrage du matériau de remplissage ;
- la seconde cavité est délimitée par au moins une paroi qui, par rapport à un plan vertical perpendiculaire à la surface à décorer de la pièce mécanique, s'écarte de ce plan vertical au fur et à mesure qu'elle s'éloigne de ladite surface à décorer de la pièce mécanique ;
- perçage d'au moins un trou conique dans un fond de la seconde cavité, ce trou conique allant en s'évasant en direction d'une surface arrière opposée à la surface à décorer de la pièce mécanique ;
- avant remplissage du volume délimité par la couche de masquage et la surface à décorer de la pièce mécanique, mise à niveau de la couche de masquage pour obtenir une surface plane et parallèle à la surface à décorer de la pièce mécanique ;
- après remplissage du volume délimité par la couche de masquage et la surface à décorer de la pièce mécanique et de la cavité sous-jacente au moyen du matériau de remplissage, usinage et finition de la surface à décorer de la couche de masquage et du matériau de remplissage ;
- après usinage et finition, l'épaisseur résiduelle de la couche de masquage et du matériau de remplissage est de l'ordre de 200 µm ;
- après usinage et finition, la couche de masquage est éliminée ;
- la couche de masquage est éliminée par attaque dans un bain chimique ;
- le matériau de remplissage est satiné ou poli.

On a observé que le fait de déposer une seconde couche d'accrochage sur la surface à décorer de la pièce mécanique, aux endroits où sont ménagées les premières cavités, permet d'améliorer sensiblement l'adhérence des éléments de décor sur la surface de la pièce à décorer, grâce à quoi il est plus facile d'effectuer les éventuelles opérations de rectification de la surface supérieure des éléments de décor après dépôt de ces derniers. Par ailleurs, on garantit une très bonne tenue des éléments de décor dans le temps. Préférentiellement, cette couche d'accrochage est réalisée en un matériau conducteur de l'électricité et peut aussi être déposée par-dessus la couche de masquage.

De même, on a observé que la force d'adhésion des éléments de décor est encore améliorée lorsque l'on usine dans l'épaisseur de la pièce mécanique à décorer des secondes cavités à la suite des premières cavités, aux endroits où doivent être reçus les éléments de décor. En effet, grâce à la présence des secondes cavités, les éléments de décor sont profondément ancrés dans la pièce mécanique à décorer et les risques de les voir se désolidariser de cette pièce mécanique sont très faibles.

### Brève description des figures

D'autres caractéristiques et avantages de la présente invention ressortiront plus clairement de la description détaillée qui suit d'un exemple de mise en oeuvre du procédé selon l'invention, cet exemple étant donné à titre purement illustratif et non limitatif seulement en liaison avec le dessin annexé sur lequel :
- la figure 1 est une vue de dessus d'un cadran de montre décoré conformément au procédé de l'invention ;
- la figure 2 est une vue en élévation d'un cadran de montre sur une surface à décorer duquel a été déposée une couche de masquage ;
- la figure 3 est une vue en élévation du cadran de montre de la figure 2 avec interposition d'une première couche d'accrochage entre la surface à décorer du cadran de montre et la couche de masquage ;
- la figure 4 est une vue en élévation et en coupe du cadran de montre selon la ligne IV-IV de la figure 1, des premières cavités ayant été ménagées dans la couche de masquage et la couche d'accrochage aux endroits où doivent être réalisés les éléments de décor ;
- la figure 5 est une vue à plus grande échelle de la région entourée d'un cercle sur la figure 4, une seconde cavité ayant été gravée dans l'épaisseur de la surface à décorer du cadran de montre pour améliorer l'ancrage des éléments de décor ;
- la figure 6 est une vue analogue à celle de la figure 5, la seconde cavité présentant une paroi intérieure inclinée pour améliorer l'ancrage des éléments de décor ;
- la figure 7 est une vue analogue à celle de la figure 5, un trou conique percé dans le cadran de montre et débouchant dans le fond de la cavité étant destiné à améliorer l'ancrage de l'élément de décor ;
- la figure 8 est une vue en élévation du cadran de montre sur la surface à décorer duquel a été déposée une seconde couche d'accrochage des éléments de décor par-dessus la couche de masquage ;
- la figure 9 est une vue en élévation du cadran de montre sur laquelle on voit que les premières cavités et les secondes cavités ont été garnies au moyen d'un matériau de remplissage ;
- la figure 10 est une vue en élévation du cadran de montre sur laquelle on voit que l'épaisseur de la couche de masquage et des éléments de décor a été réduite de moitié au cours des opérations de finition de la surface supérieure des éléments de décor, et
- la figure 11 est une vue en élévation du cadran de montre sur laquelle la couche de masquage et les couches d'accrochage ont été éliminées.

### Description détaillée d'un mode de réalisation de l'invention

La présente invention procède de l'idée générale inventive qui consiste à former des éléments de décor sur une surface d'une pièce mécanique à décorer, en particulier des cadrans de montre et, plus généralement, des éléments d'habillage de pièces d'horlogerie tels que des lunettes, des carrures ou bien encore des maillons de bracelet ainsi que des bijoux. Pour atteindre ce résultat, la présente invention enseigne de déposer directement sur la surface à décorer de la pièce mécanique un masque de type sacrificiel, c'est-à-dire un masque destiné à être éliminé à la fin des opérations de décoration de la pièce mécanique. Une fois le masque déposé en contact intime avec la surface de la pièce mécanique à décorer, puis structuré de manière à y créer des premières cavités que l'on va remplir au moyen du matériau dans lequel on souhaite que les éléments de décor soient réalisés, on usine et on apprête éventuellement la surface formée par le dessus du masque et des éléments de décor, puis on élimine le masque, typiquement par attaque dans un bain chimique. Pour améliorer davantage encore la tenue des éléments de décor sur la surface de la pièce mécanique à décorer, la présente invention enseigne de déposer, après dépôt de la couche de masquage, une seconde couche d'accrochage sur la surface à décorer, aux endroits où sont ménagées les premières cavités, pour favoriser l'accrochage des éléments de décor. Par un choix judicieux du matériau utilisé pour réaliser la seconde couche d'accrochage, on garantit la très bonne adhérence des éléments de décor sur la surface de la pièce mécanique à décorer. Cela facilite les opérations de rectification et de finition ultérieures des éléments de décor ainsi que la tenue mécanique dans le temps de ces derniers.

Conformément à l'invention, on commence par se munir d'une pièce mécanique à décorer. Dans l'exemple illustré au dessin, cette pièce mécanique à décorer est un cadran de montre 1. Bien entendu, cet exemple est donné à titre purement illustratif et nullement limitatif seulement, la pièce mécanique à décorer pouvant être de tout type comme un élément d'habillage pour pièce d'horlogerie (lunette, maillon de bracelet, carrure etc.), un pont, une platine, une masse oscillante ou bien encore un article de bijouterie. La seule contrainte qui pèse sur cette pièce mécanique que l'on souhaite décorer est qu'elle doit être réalisée dans un matériau dont les propriétés mécaniques ne sont pas modifiées dans la gamme de températures mises en jeu par le procédé de l'invention. En d'autres termes, la pièce mécanique ne doit pas se déformer, ramollir, voire fondre durant les opérations de décoration conformes à l'invention.

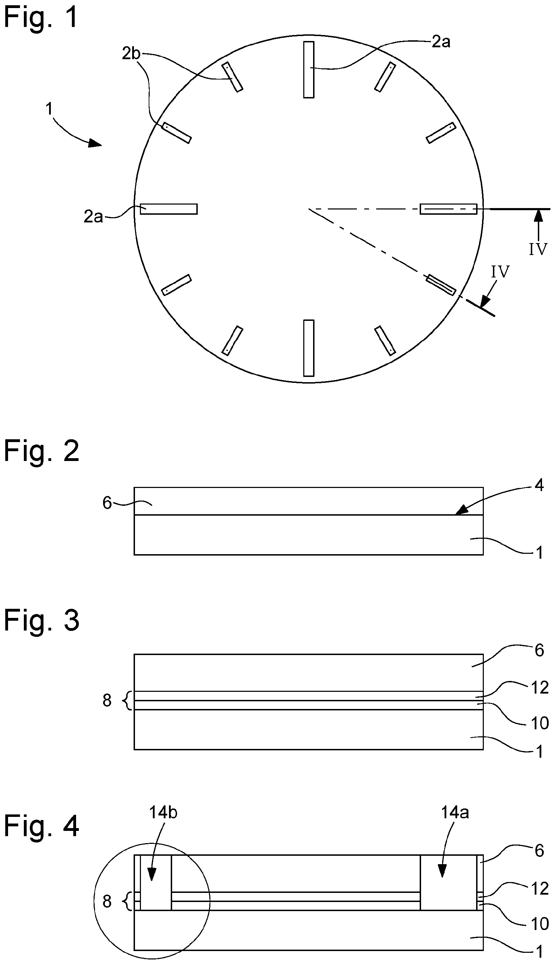

Au sens de l'invention, le cadran de montre 1 est destiné à être agrémenté d'au moins un élément de décor dont les dimensions et l'épaisseur sont fonctions des besoins. A titre d'exemple, dans le cas où la pièce mécanique à décorer est un cadran de montre 1, les éléments de décor peuvent servir à former les heures index : comme illustré sur la figure 1, quatre premiers éléments de décor 2a d'une première dimension peuvent par exemple être utilisés pour marquer midi, trois heures, six heures et neuf heures sur le cadran de montre 1, tandis que huit seconds éléments de décor 2b d'une seconde dimension peuvent être utilisés pour marquer les autres heures pleines et compléter le tour d'heure.

Une fois muni du cadran de montre 1, il convient de déposer sur une surface à décorer 4 de ce cadran de montre 1 -typiquement la surface supérieure de ce cadran de montre 1- une couche de masquage 6 destinée à former un masque de type sacrificiel (voir figure 2). Par « sacrificiel », on entend une couche de masquage qui, une fois qu'elle aura rempli sa fonction, sera éliminée. Cette couche de masquage 6 aura une épaisseur qui sera fonction de la hauteur dont on veut que les éléments de décor 2a, 2b fassent finalement saillie au-dessus de la surface à décorer 4 du cadran de montre 1 une fois les opérations d'usinage terminées. A titre d'exemple seulement, l'épaisseur de la couche de masquage 6 est de 400 µm. Au minimum, l'épaisseur de la couche de masquage 6 devra être égale à la hauteur dont on veut que les éléments de décor 2a, 2b dépassent de la surface à décorer 4 une fois les opérations d'usinage achevées.

A titre d'exemple préféré seulement, la couche de masquage 6 peut être formée d'une couche de polymère ou d'une couche métallique. Dans le cas où la couche de masquage 6 est métallique, elle peut notamment être réalisée en argent, en cuivre ou bien encore en nickel et est déposée sur le cadran de montre 1 par toute technique appropriée telle que l'électroformage.

On notera que, selon l'invention, avant dépôt de la couche de masquage 6, on dépose sur la surface à décorer 4 du cadran de montre 1 une première couche d'accrochage 8 afin d'optimiser l'adhésion de la couche de masquage 6 (voir figure 3). Préférentiellement, cette première couche d'accrochage 8 est conductrice de l'électricité et se compose, par exemple, d'une sous-couche de chrome 10 par-dessus laquelle est déposée une sous-couche d'or 12. Une série de tests a permis de déterminer qu'une épaisseur de l'ordre de 50 nm pour chacune des sous-couches de chrome 10 et d'or 12 donnait d'excellents résultats pour ce qui est de la force d'adhésion de la couche de masquage 6 sur le cadran de montre 1. La première couche d'accrochage 8 est préférentiellement déposée par évaporation sous vide ou bien par pulvérisation cathodique. Le dépôt de la première couche d'accrochage 8 est nécessaire en particulier dans le cas où le cadran de montre 1 est réalisé en un matériau non-conducteur de l'électricité tel que céramique, pierre ou émail. Bien entendu, le cadran de montre 1 peut également être réalisé en un matériau métallique conducteur de l'électricité. Dans ce cas, la couche d'accrochage 8 peut être omise dans la mesure où la couche de masquage 6 peut être déposée par exemple par électroformage directement sur la surface à décorer 4 du cadran de montre 1.

Une fois la première couche d'accrochage 8 et la couche de masquage 6 déposées à la suite l'une de l'autre sur la surface à décorer 4 du cadran de montre 1, il convient de ménager dans la couche de masquage 6 et la couche d'accrochage 8 au moins une première cavité à l'endroit qui coïncide avec l'emplacement sur la surface à décorer 4 du cadran de montre 1 où doit être réalisé l'élément de décor (voir figure 4), et dont le contour et la hauteur correspondent à la forme et aux dimensions des éléments de décor recherchés. Dans le cas décrit ici, ces premières cavités seront au nombre de douze, quatre cavités 14a correspondant aux quatre premiers éléments de décor 2a utilisés pour marquer midi, trois heures, six heures et neuf heures sur le cadran de montre 1, et huit cavités 14b correspondant aux éléments de décor 2b utilisés pour marquer les autres heures pleines et compléter le tour d'heure sur le cadran de montre 1. On peut envisager que les douze cavités 14a, 14b soient de même forme, par exemple carrée ou rectangulaire, mais que les dimensions des quatre cavités 14a soient plus grandes que celles des huit cavités 14b. Ces douze cavités 14a, 14b sont découpées dans la couche de masquage 6 et la première couche d'accrochage 8 par tout moyen approprié tel qu'un faisceau laser.

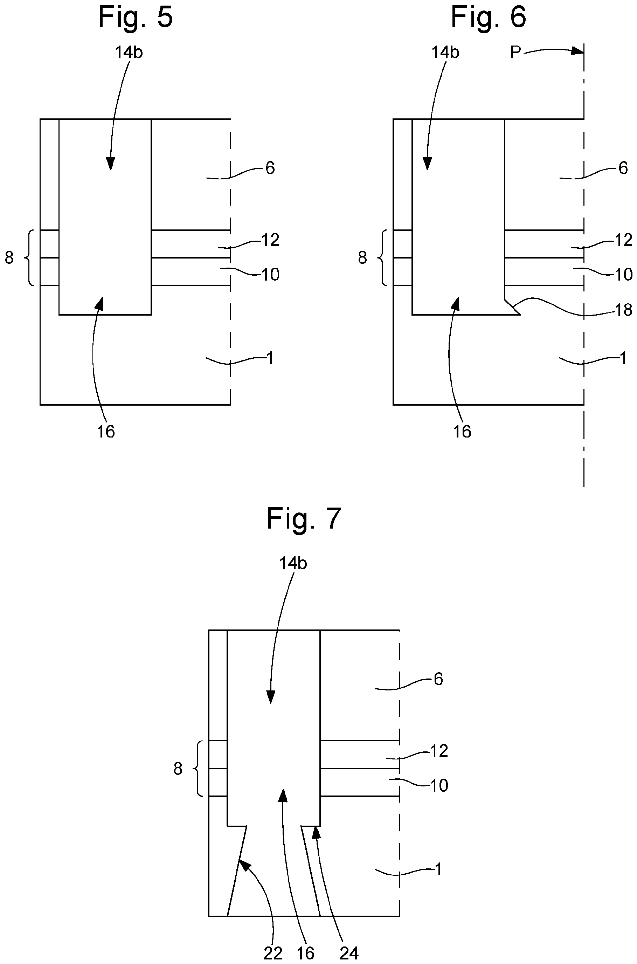

Selon un mode préféré mais non limitatif d'exécution de l'invention, on grave, à travers les premières cavités 14a, 14b ménagées dans la couche de masquage 6 et la couche d'accrochage 8, des secondes cavités 16 dans la surface à décorer 4 du cadran de montre 1 (voir figure 5). Ces secondes cavités 16 qui, de préférence, sont usinées en même temps que les premières cavités 14a, 14b, sont destinées à améliorer l'immobilisation des éléments de décor 2a, 2b sur la surface à décorer 4 du cadran de montre 1. A titre d'exemple seulement, la profondeur de ces secondes cavités 16 est choisie de l'ordre de 20 µm.

Pour améliorer davantage encore l'immobilisation des éléments de décor 2a, 2b, les secondes cavités 16 sont munies de moyens d'ancrage. Selon une première forme d'exécution de l'invention (voir figure 6), ces moyens d'ancrage sont constitués par au moins une face 18 de la paroi 20 de la seconde cavité 16 qui, par rapport à un plan vertical P perpendiculaire à la surface à décorer 4 du cadran de montre 1, s'écarte de ce plan vertical P au fur et à mesure qu'elle s'éloigne de ladite surface à décorer 4 du cadran de montre 1. Grâce à la présence de cette face 18 inclinée, on comprend qu'une fois les secondes cavités 16 remplies au moyen du matériau de remplissage, les éléments de décor 2a, 2b résultants ne peuvent plus se dégager des secondes cavités 16 et sont ainsi ancrés de manière permanente sur le cadran de montre 1.

Une autre forme d'exécution de l'invention qui vise également à améliorer l'ancrage des éléments de décor 2a, 2b sur la surface à décorer 4 du cadran de montre 1 prévoit de percer au moins un trou conique 22 dans le fond 24 des secondes cavités 16, ces trous coniques 22 allant en s'évasant en direction de la surface arrière 26 du cadran de montre 1, opposée à la surface à décorer 4 (voir figure 7). Dans ce cas aussi, on comprend qu'une fois les secondes cavités 16 et les trous coniques 22 remplis par le matériau de remplissage, il n'est plus possible aux éléments de décor 2a, 2b de se dégager.

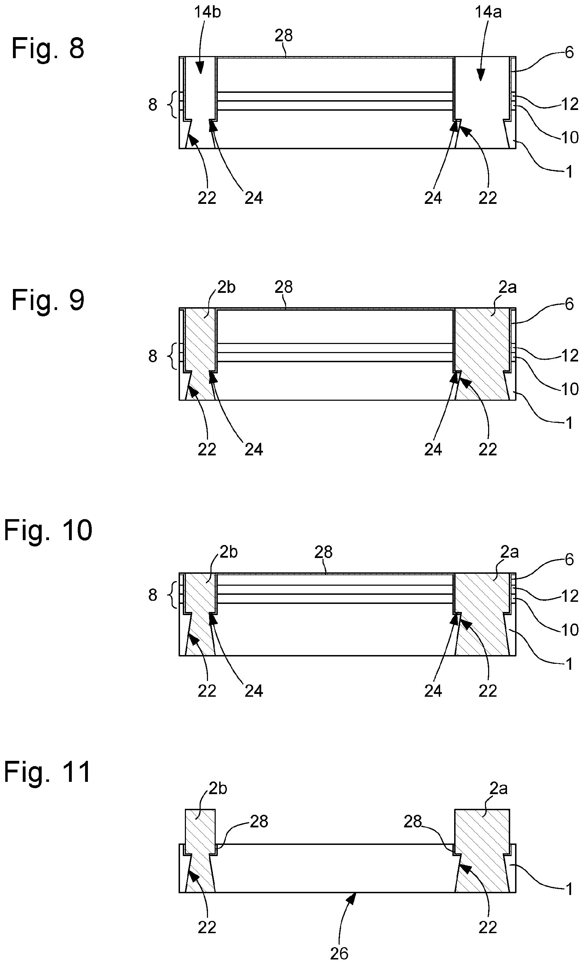

Une fois les premières cavités 14a, 14b usinées, et les secondes cavités 16 éventuellement gravées, on dépose une seconde couche d'accrochage 28 réalisée en un matériau conducteur de l'électricité sur la surface à décorer 4, aux endroits où sont ménagées les premières cavités 14a, 14b, pour favoriser l'accrochage des éléments de décor 2a, 2b (voir figure 8). Bien entendu, pour des questions de facilité de mise en oeuvre du procédé, la seconde couche d'accrochage 28 peut aussi être déposée par-dessus la couche de masquage 6. Cette seconde couche d'accrochage 28 des éléments de décor 2a, 2b est réalisée en un matériau conducteur de l'électricité déposé par évaporation sous vide ou par pulvérisation cathodique. A titre d'exemple non-limitatif seulement, la seconde couche d'accrochage 28 se compose d'une sous-couche d'or (Au) par-dessus laquelle est déposée une sous-couche de chrome (Cr), ces deux sous-couches d'or et de chrome ayant chacune une épaisseur de l'ordre de 50 nm. La seconde couche d'accrochage 28, en favorisant l'accrochage du matériau de remplissage dans lequel vont être réalisés les éléments de décor 2a, 2b, va favoriser l'accrochage de ces éléments de décor 2a, 2b sur la surface à décorer 4 et garantir leur bonne tenue mécanique dans le temps.

Une fois la seconde couche d'accrochage 28 déposée, il convient donc de remplir les premières cavités 14a, 14b ainsi que les secondes cavités 16 le cas échéant au moyen d'un matériau de remplissage (figure 9). Selon le cas, le matériau de remplissage pourra être un métal cristallin ou un métal amorphe. Dans le cas d'un matériau de remplissage de type métal amorphe, on utilisera de préférence un alliage de platine amorphe, ou bien un alliage de palladium amorphe ou bien un alliage de zirconium amorphe.

On notera qu'avant remplissage du volume délimité par la couche de masquage 6 et la surface à décorer 4 du cadran de montre 1, la couche de masquage 6 peut être mise à niveau pour obtenir une surface plane et parallèle à la surface à décorer 4 du cadran de montre 1.

Comme déjà mentionné ci-dessus, l'épaisseur de la couche de masquage 6 peut être fixée à 400 µm par exemple. A ce stade de l'invention, l'épaisseur des éléments de décor 2a, 2b est donc également de l'ordre de 400 µm. Si l'on souhaite qu'au final, l'épaisseur des éléments de décor 2a, 2b soit de 200 µm au-dessus de la surface à décorer 4, cela signifie que l'on dispose d'un surplus de matériau de remplissage d'une épaisseur de l'ordre de 200 µm pour rectifier les éléments de décor 2a, 2b et parfaire leur état de surface, notamment en les satinant ou en les polissant (voir figure 10).

Une fois les opérations de finition des éléments de décor 2a, 2b terminées, la couche de masquage 6 est éliminée, typiquement par attaque dans un bain chimique, et les éléments de décor 2a, 2b sont complètement révélés (voir figure 11).

Il va de soi que la présente invention n'est pas limitée aux modes de réalisation qui viennent d'être décrits, et que diverses modifications et variantes simples peuvent être envisagées par l'homme du métier sans sortir du cadre de l'invention tel que défini par les revendications annexées.

### Nomenclature

1. Cadran de montre
2a, 2b. Eléments de décor
4. Surface à décorer
6. Couche de masquage
8. Première couche d'accrochage
10. Couche de chrome
12. Couche d'or
14a, 14b. Premières cavités
16. Secondes cavités
18. Face
20. Paroi
22. Trou conique
24. Fond
26. Surface arrière
28. Seconde couche d'accrochage

## Revendications

1. Procédé de décoration d'au moins une surface à décorer (4) d'une pièce mécanique comprenant la succession des étapes suivantes :
- se munir de la pièce mécanique à décorer sur laquelle on souhaite réaliser au moins un élément de décor (2a, 2b) selon une épaisseur et un contour prédéterminés ;
- déposer sur la au moins une surface à décorer (4) de la pièce mécanique une première couche d'accrochage (8) ;
- déposer sur la au moins une surface à décorer (4) de la pièce mécanique une couche de masquage (6) dotée d'une épaisseur au moins égale à l'épaisseur du au moins un élément de décor (2a, 2b) à réaliser et dont l'accrochage est favorisé par la première couche d'accrochage (8) ;
- ménager dans la couche de masquage (6) au moins une première cavité (14a, 14b) qui coïncide avec l'emplacement sur la au moins une surface à décorer (4) de la pièce mécanique où doit être réalisé le au moins un élément de décor (2a, 2b), la au moins une première cavité (14a, 14b) présentant un contour qui correspond au contour du au moins un élément de décor (2a, 2b) à réaliser et définissant un volume avec la au moins une surface à décorer (4) de la pièce mécanique ; ledit procédé étant **caractérisé en ce qu'**il comprend la succession des étapes suivantes :
- déposer sur la au moins une surface à décorer (4) de la pièce mécanique, à l'endroit où est ménagée la au moins une première cavité (14a, 14b), une seconde couche d'accrochage (28) pour favoriser l'accrochage du au moins un élément de décor (2a, 2b) ;
- remplir le volume délimité par la au moins une première cavité (14a, 14b) au moyen d'un matériau de remplissage dans lequel le au moins un élément de décor (2a, 2b) est destiné à être réalisé ;
- éliminer la couche de masquage (6).

2. Procédé de décoration selon la revendication 1, **caractérisé en ce qu'**à la suite de la au moins une première cavité (14a, 14b), on ménage au moins une seconde cavité (16) dans la au moins une surface à décorer (4) de la pièce mécanique.

3. Procédé de décoration selon la revendication 2, **caractérisé en ce que** la seconde couche d'accrochage (28) est déposée sur la au moins une surface à décorer (4), aux endroits où est ménagée la au moins une seconde cavité (16), pour favoriser l'accrochage du au moins un élément de décor (2a, 2b).

4. Procédé de décoration selon l'une des revendications 2 ou 3, **caractérisé en ce que** la première couche d'accrochage (8) de la couche de masquage (6) et la seconde couche d'accrochage (28) du au moins un élément de décor (2a, 2b) sont déposées par évaporation sous vide ou bien par pulvérisation cathodique.

5. Procédé de décoration selon la revendication 4, **caractérisé en ce que** la première couche d'accrochage (8) de la couche de masquage (6) et la seconde couche d'accrochage (28) du au moins un élément de décor (2a, 2b) sont réalisées en un matériau conducteur de l'électricité.

6. Procédé de décoration selon la revendication 5, **caractérisé en ce que** la première couche d'accrochage (8) de la couche de masquage (6) et la seconde couche d'accrochage (28) du au moins un élément de décor (2a, 2b) se composent d'une couche de chrome (10) par-dessus laquelle est déposée une couche d'or (12).

7. Procédé de décoration selon la revendication 6, **caractérisé en ce que** la couche de chrome (10) et la couche d'or (12) ont chacune une épaisseur de sensiblement 50 nm.

8. Procédé de décoration selon l'une des revendications 5 à 7, **caractérisé en ce que** la couche de masquage (6) est métallique.

9. Procédé de décoration selon la revendication 8, **caractérisé en ce que** la couche de masquage (6) est réalisée en argent (Ag), en cuivre (Cu) ou en nickel (Ni).

10. Procédé de décoration selon la revendication 9, **caractérisé en ce que** l'épaisseur de la couche de masquage (6) est d'au moins 20 µm.

11. Procédé de décoration selon l'une des revendications 8 à 10, **caractérisé en ce que** la couche de masquage (6) est déposée sur la au moins une surface à décorer (4) de la pièce mécanique par électroformage.

12. Procédé de décoration selon l'une des revendications 2 à 11, **caractérisé en ce que** le matériau de remplissage est un métal cristallin ou un métal amorphe.

13. Procédé de décoration fabrication selon la revendication 12, **caractérisé en ce que** le métal cristallin est de l'or ou du nickel.

14. Procédé de décoration selon la revendication 12, **caractérisé en ce que** le métal amorphe est un alliage de platine amorphe, un alliage de palladium amorphe ou bien un alliage de zirconium amorphe.

15. Procédé de décoration selon l'une des revendications 2 à 14, **caractérisé en ce que** la au moins une première cavité (14a, 14b) et la au moins une seconde cavité (16) sont gravées simultanément au moyen d'un faisceau laser.

16. Procédé de décoration selon la revendication 15, **caractérisé en ce que** la profondeur de la au moins une seconde cavité (16) gravée dans la au moins une surface à décorer (4) de la pièce mécanique n'excède pas 20 µm.

17. Procédé de décoration selon l'une des revendications 2 à 16, **caractérisé en ce que** la au moins une seconde cavité (16) gravée dans la au moins une surface à décorer (4) de la pièce mécanique comprend des moyens d'ancrage du au moins un élément de décor (2a, 2b).

18. Procédé de décoration selon la revendication 17, **caractérisé en ce que** la au moins une seconde cavité (16) est délimitée par une paroi (20) dont au moins une face (18) s'écarte d'un plan (P) perpendiculaire à la au moins une surface à décorer (4) de la pièce mécanique au fur et à mesure que cette face (18) s'éloigne de ladite au moins une surface à décorer (4) de la pièce mécanique.

19. Procédé de décoration selon l'une des revendications 17 et 18, **caractérisé en ce que** l'on perce au moins un trou conique (22) dans un fond (24) de la au moins une seconde cavité (16), ce au moins un trou conique (22) allant en s'évasant en direction d'une surface arrière (26) de la pièce mécanique, opposée à la au moins une surface à décorer (4).

20. Procédé de décoration selon l'une des revendications 1 à 18, **caractérisé en ce qu'**avant dépôt de la couche de masquage (6), on met à niveau la première couche d'accrochage (8) qui est destinée à favoriser l'accrochage de la couche de masquage (6) pour obtenir une surface plane et parallèle à la surface à décorer (4) de la pièce mécanique (1).

21. Procédé de décoration selon l'une des revendications 1 à 20, **caractérisé en ce que**, après remplissage du volume délimité par la au moins une première cavité (14a, 14b) ménagée dans la couche de masquage (6) au moyen du matériau de remplissage et avant élimination de la couche de masquage (6), on usine et on termine la surface supérieure du au moins un élément de décor (2a, 2b).

22. Procédé de décoration selon la revendication 21, **caractérisé en ce que** le au moins un élément de décor (2a, 2b) et la couche de masquage (6) sont soumises à l'une au moins des opérations de finition suivantes : sablage, brossage, satinage ou polissage.

23. Procédé de décoration selon l'une des revendications 21 ou 22, **caractérisé en ce qu'**après usinage et finition, l'épaisseur résiduelle de la couche de masquage (6) et du au moins un élément de décor (2a, 2b) est de l'ordre de 200 µm.

24. Procédé de décoration selon l'une des revendications 21 à 23, **caractérisé en ce que**, après usinage et finition du au moins un élément de décor (2a, 2b), la couche de masquage (6) est éliminée.

25. Procédé de décoration selon la revendication 24, **caractérisé en ce que** la couche de masquage (6) est éliminée par attaque dans un bain chimique.

## Patentansprüche

1. Verfahren zum Verzieren mindestens einer zu verzierenden Oberfläche (4) eines mechanischen Teils, umfassend die Folge der folgenden Schritte:
- Bereitstellen des zu verzierenden mechanischen Teils, auf dem mindestens ein Verzierungselement (2a, 2b) entsprechend einer vorbestimmten Dicke und einer vorbestimmten Kontur hergestellt werden soll;
- Aufbringen einer ersten Haftschicht (8) auf der mindestens einen zu verzierenden Oberfläche (4) des mechanischen Teils;
- Aufbringen einer Maskierungsschicht (6), die mit einer Dicke versehen ist, die mindestens der Dicke des mindestens einen herzustellenden Verzierungselements (2a, 2b) entspricht, und deren Haftung durch die erste Haftschicht (8) begünstigt wird, auf der mindestens einen zu verzierenden Oberfläche (4) des mechanischen Teils;
- Aussparen mindestens eines ersten Hohlraums (14a, 14b) in der Maskierungsschicht (6), der mit der Position auf der mindestens einen zu verzierenden Oberfläche (4) des mechanischen Teils übereinstimmt, an der das mindestens eine Verzierungselement (2a, 2b) hergestellt werden soll, wobei der mindestens eine erste Hohlraum (14a, 14b) eine Kontur aufweist, die der Kontur des mindestens einen herzustellenden Verzierungselements (2a, 2b) entspricht, und ein Volumen mit der mindestens einen zu verzierenden Oberfläche (4) des mechanischen Teils definiert; wobei das Verfahren **dadurch gekennzeichnet ist, dass** es die Reihenfolge der folgenden Schritte umfasst:
- Aufbringen einer zweiten Haftschicht (28) auf der mindestens einen zu verzierenden Oberfläche (4) des mechanischen Teils an der Position, an der der mindestens eine erste Hohlraum (14a, 14b) vorgesehen ist, um die Haftung des mindestens einen Verzierungselements (2a, 2b) zu begünstigen;
- Füllen des durch den mindestens einen ersten Hohlraum (14a, 14b) begrenzten Volumens mit einem Füllmaterial, in dem das mindestens eine Verzierungselement (2a, 2b) hergestellt werden soll;
- Entfernen der Maskierungsschicht (6).

2. Verzierungsverfahren nach Anspruch 1, **dadurch gekennzeichnet, dass** im Anschluss an den mindestens einen ersten Hohlraum (14a, 14b) mindestens ein zweiter Hohlraum (16) in die mindestens eine zu verzierende Oberfläche (4) des mechanischen Teils vorgesehen wird.

3. Verzierungsverfahren nach Anspruch 2, **dadurch gekennzeichnet, dass** die zweite Haftschicht (28) auf der mindestens einen zu verzierenden Oberfläche (4) an den Positionen aufgebracht wird, an denen der mindestens eine zweite Hohlraum (16) vorgesehen ist, um die Haftung des mindestens einen Verzierungselements (2a, 2b) zu begünstigen.

4. Verzierungsverfahren nach einem der Ansprüche 2 oder 3, **dadurch gekennzeichnet, dass** die erste Haftschicht (8) der Maskierungsschicht (6) und die zweite Haftschicht (28) des mindestens einen Verzierungselements (2a, 2b) durch Vakuumverdampfung oder durch Kathodenzerstäubung aufgebracht werden.

5. Verzierungsverfahren nach Anspruch 4, **dadurch gekennzeichnet, dass** die erste Haftschicht (8) der Maskierungsschicht (6) und die zweite Haftschicht (28) des mindestens einen Verzierungselements (2a, 2b) aus einem elektrischen leitfähigen Material hergestellt werden.

6. Verzierungsverfahren nach Anspruch 5, **dadurch gekennzeichnet, dass** die erste Haftschicht (8) der Maskierungsschicht (6) und die zweite Haftschicht (28) des mindestens einen Verzierungselements (2a, 2b) aus einer Chromschicht (10) bestehen, über die eine Goldschicht (12) aufgebracht wird.

7. Verzierungsverfahren nach Anspruch 6, **dadurch gekennzeichnet, dass** die Chromschicht (10) und die Goldschicht (12) jeweils eine Dicke aufweisen, die im Wesentlichen 50 nm beträgt.

8. Verzierungsverfahren nach einem der Ansprüche 5 bis 7, **dadurch gekennzeichnet, dass** die Maskierungsschicht (6) metallisch ist.

9. Verzierungsverfahren nach Anspruch 8, **dadurch gekennzeichnet, dass** die Maskierungsschicht (6) aus Silber (Ag), Kupfer (Cu) oder Nickel (Ni) hergestellt wird.

10. Verzierungsverfahren nach Anspruch 9, **dadurch gekennzeichnet, dass** die Dicke der Maskierungsschicht (6) mindestens 20 µm beträgt.

11. Verzierungsverfahren nach einem der Ansprüche 8 bis 10, **dadurch gekennzeichnet, dass** die Maskierungsschicht (6) durch Elektroformung auf die mindestens eine zu verzierende Oberfläche (4) des mechanischen Teils aufgetragen wird.

12. Verzierungsverfahren nach einem der Ansprüche 2 bis 11, **dadurch gekennzeichnet, dass** das Füllmaterial ein kristallines Metall oder ein amorphes Metall ist.

13. Verzierungsverfahren nach Anspruch 12, **dadurch gekennzeichnet, dass** das kristalline Metall Gold oder Nickel ist.

14. Verzierungsverfahren nach Anspruch 12, **dadurch gekennzeichnet, dass** das amorphe Metall eine amorphe Platinlegierung, eine amorphe Palladiumlegierung oder eine amorphe Zirkoniumlegierung ist.

15. Verzierungsverfahren nach einem der Ansprüche 2 bis 14, **dadurch gekennzeichnet, dass** der mindestens eine erste Hohlraum (14a, 14b) und der mindestens eine zweite Hohlraum (16) gleichzeitig mit einem Laserstrahl graviert werden.

16. Verzierungsverfahren nach Anspruch 15, **dadurch gekennzeichnet, dass** die Tiefe des mindestens einen zweiten Hohlraums (16), der in die mindestens eine zu verzierende Oberfläche (4) des mechanischen Teils graviert ist, 20 µm nicht überschreitet.

17. Verzierungsverfahren nach einem der Ansprüche 2 bis 16, **dadurch gekennzeichnet, dass** der mindestens eine zweite Hohlraum (16), der in die mindestens eine zu verzierende Oberfläche (4) des mechanischen Teils graviert ist, Haftmittel des mindestens einen Verzierungselements (2a, 2b) umfasst.

18. Verzierungsverfahren nach Anspruch 17, **dadurch gekennzeichnet, dass** der mindestens eine zweite Hohlraum (16) durch eine Wand (20) begrenzt ist, von der mindestens eine Seite (18) allmählich von einer Ebene (P) abweicht, die senkrecht zur mindestens einen zu verzierenden Oberfläche (4) des mechanischen Teils verläuft, wenn sich diese Fläche (18) von der mindestens einen zu verzierenden Oberfläche (4) des mechanischen Teils entfernt.

19. Verzierungsverfahren nach einem der Ansprüche 17 bis 18, **dadurch gekennzeichnet, dass** mindestens ein konisches Loch (22) in einen Boden (24) des mindestens einen zweiten Hohlraums (16) gebohrt wird, wobei sich dieses mindestens eine konische Loch (22) zu einer hinteren Oberfläche (26) des mechanischen Teils hin erweitert, die der mindestens einen zu verzierenden Fläche (4) gegenüberliegt.

20. Verzierungsverfahren nach einem der Ansprüche 1 bis 18, **dadurch gekennzeichnet, dass** vor dem Aufbringen der Maskierungsschicht (6) die erste Haftschicht (8) eingeebnet wird, die dazu bestimmt ist, die Haftung der Maskierungsschicht (6) zu begünstigen, um eine ebene Oberfläche zu erhalten, die parallel zu der zu verzierenden Oberfläche (4) des mechanischen Teils (1) verläuft.

21. Verzierungsverfahren nach einem der Ansprüche 1 bis 20, **dadurch gekennzeichnet, dass** nach dem Füllen des Volumens, das durch den mindestens einen ersten Hohlraum (14a, 14b), der in der Maskierungsschicht (6) vorgesehen ist, begrenzt ist, mit dem Füllmaterial und vor dem Entfernen der Maskierungsschicht (6) die obere Oberfläche des mindestens einen Verzierungselements (2a, 2b) bearbeitet und fertiggestellt wird.

22. Verzierungsverfahren nach Anspruch 21, **dadurch gekennzeichnet, dass** das mindestens eine Verzierungselement (2a, 2b) und die Maskierungsschicht (6) mindestens einer der folgenden Fertigstellungsvorgänge unterzogen werden: Sandstrahlen, Bürsten, Satinierung oder Polieren.

23. Verzierungsverfahren nach einem der Ansprüche 21 oder 22, **dadurch gekennzeichnet, dass** die Restdicke der Maskierungsschicht (6) und des mindestens einen Verzierungselements (2a, 2b) nach dem Bearbeiten und Fertigstellen im Bereich von 200 µm liegt.

24. Verzierungsverfahren nach einem der Ansprüche 21 bis 23, **dadurch gekennzeichnet, dass** die Maskierungsschicht (6) nach dem Bearbeiten und Fertigstellen des mindestens einen Verzierungselements (2a, 2b) entfernt wird.

25. Verzierungsverfahren nach Anspruch 24, **dadurch gekennzeichnet, dass** die Maskierungsschicht (6) durch Ätzen in einem chemischen Bad entfernt wird.

## Claims

1. Method for decorating at least one surface to be decorated (4) of a mechanical part comprising the following steps of:
- taking the mechanical part to be decorated, on which at least one decoration element (2a, 2b) is sought to be produced according to a predetermined thickness and contour;
- depositing, on the at least one surface to be decorated (4) of the mechanical part, a first bonding layer (8);
- depositing, on the at least one surface to be decorated (4) of the mechanical part, a masking layer (6) having a thickness that is at least equal to the thickness of the at least one decoration element (2a, 2b) to be produced and the bonding of which is facilitated by the first bonding layer (8);
- making, in the masking layer (6), at least one first cavity (14a, 14b) that coincides with the location on the at least one surface to be decorated (4) of the mechanical part where the at least one decoration element (2a, 2b) is to be produced, the at least one first cavity (14a, 14b) having a contour that corresponds to the contour of the at least one decoration element (2a, 2b) to be produced and defining a volume with the at least one surface to be decorated (4) of the mechanical part; said method being **characterised in that** it comprises the succession of the following steps :
- depositing, on the at least one surface to be decorated (4) of the mechanical part, in the location where the at least one first cavity (14a, 14b) is made, a second bonding layer (28) to facilitate the bonding of the at least one decoration element (2a, 2b);
- filling the volume delimited by the at least one first cavity (14a, 14b) with a filling material in which the at least one decoration element (2a, 2b) is intended to be produced;
- removing the masking layer (6).

2. Decorating method according to claim 1, **characterised in that**, following the at least one first cavity (14a, 14b), at least one second cavity (16) is made in the at least one surface to be decorated (4) of the mechanical part.

3. Decorating method according to claim 2, **characterised in that** the second bonding layer (28) is deposited on the at least one surface to be decorated (4), in the locations where the at least one second cavity (16) is made, to facilitate the bonding of the at least one decoration element (2a, 2b).

4. Decorating method according to claim 2 or 3, **characterised in that** the first bonding layer (8) of the masking layer (6) and the second bonding layer (28) of the at least one decoration element (2a, 2b) are deposited by vacuum evaporation or by cathodic sputtering.

5. Decorating method according to claim 4, **characterised in that** the first bonding layer (8) of the masking layer (6) and the second bonding layer (28) of the at least one decoration element (2a, 2b) are made of an electrically-conductive material.

6. Decorating method according to claim 5, **characterised in that** the first bonding layer (8) of the masking layer (6) and the second bonding layer (28) of the at least one decoration element (2a, 2b) are formed by a layer of chromium (10) on top of which a layer of gold (12) is deposited.

7. Decorating method according to claim 6, **characterised in that** the layer of chromium (10) and the layer of gold (12) each have a thickness that is substantially equal to 50 nm.

8. Decorating method according to one of claims 5 to 7, **characterised in that** the masking layer (6) is metallic.

9. Decorating method according to claim 8, **characterised in that** the masking layer (6) is made of silver (Ag), copper (Cu) or nickel (Ni).

10. Decorating method according to claim 9, **characterised in that** the thickness of the masking layer (6) is at least equal to 20 µm.

11. Decorating method according to one of claims 8 to 10, **characterised in that** the masking layer (6) is deposited on the at least one surface to be decorated (4) of the mechanical part by electroforming.

12. Decorating method according to one of claims 2 to 11, **characterised in that** the filling material is a crystalline metal or an amorphous metal.

13. Decorating method according to claim 12, **characterised in that** the crystalline metal is gold or nickel.

14. Decorating method according to claim 12, **characterised in that** the amorphous metal is an amorphous platinum alloy, an amorphous palladium alloy, or an amorphous zirconium alloy.

15. Decorating method according to one of claims 2 to 14, **characterised in that** the at least one first cavity (14a, 14b) and the at least one second cavity (16) are simultaneously etched using a laser beam.

16. Decorating method according to claim 15, **characterised in that** the depth of the at least one second cavity (16) etched in the at least one surface to be decorated (4) of the mechanical part does not exceed 20 µm.

17. Decorating method according to one of claims 2 to 16, **characterised in that** the at least one second cavity (16) etched in the at least one surface to be decorated (4) of the mechanical part comprises means for anchoring the at least one decoration element (2a, 2b).

18. Decorating method according to claim 17, **characterised in that** the at least one second cavity (16) is delimited by a wall (20), at least one face (18) thereof progressively deviating from a plane (P) perpendicular to the at least one surface to be decorated (4) of the mechanical part as this face (18) moves away from said at least one surface to be decorated (4) of the mechanical part.

19. Decorating method according to one of claims 17 and 18, **characterised in that** at least one conical hole (22) is drilled in a bottom (24) of the at least one second cavity (16), this at least one conical hole (22) flaring out towards a rear surface (26) of the mechanical part, opposite the at least one surface to be decorated (4).

20. Decorating method according to one of claims 1 to 18, **characterised in that** before depositing the masking layer (6), the first bonding layer (8) is levelled, which layer is intended to facilitate the bonding of the masking layer (6) to obtain a planar surface parallel to the surface to be decorated (4) of the mechanical part (1).

21. Decorating method according to one of claims 1 to 20, **characterised in that** after filling the volume delimited by the at least one first cavity (14a, 14b) made in the masking layer (6) with the filling material and before removing the masking layer (6), the top surface of the at least one decoration element (2a, 2b) is machined and finished.

22. Decorating method according to claim 21, **characterised in that** the at least one decoration element (2a, 2b) and the masking layer (6) are subjected to at least one of the following finishing operations: sanding, brushing, glossing or polishing.

23. Decorating method according to one of claims 21 and 22, **characterised in that** after machining and finishing, the residual thickness of the at least one masking layer (6) and of the at least one decoration element (2a, 2b) is equal to about 200 µm.

24. Decorating method according to one of claims 21 to 23, **characterised in that** after machining and finishing the at least one decoration element (2a, 2b), the masking layer (6) is removed.

25. Decorating method according to claim 24, **characterised in that** the masking layer (6) is removed by etching in a chemical bath.
